# EUROPÄISCHE PATENTSCHRIFT

(11) **EP 3 966 855 B1**
(45) Veröffentlichungstag und Bekanntmachung des Hinweises auf die Patenterteilung: **22.10.2025**
(21) Anmeldenummer: 20724089.6
(22) Anmeldetag: 05.05.2020
(51) Int. Cl.: H01L 21/683

(54) **VAKUUMSPANNVORRICHTUNG**
VACUUM CLAMPING DEVICE
DISPOSITIF DE SERRAGE À VIDE

(30) Priorität: 10.05.2019 DE 102019112318
(43) Veröffentlichungstag der Anmeldung: 16.03.2022
(73) Patentinhaber: WiTrins s.r.o., 25064 Hovorcovice (CZ)
(72) Erfinder: WIESER, Roman Franz, 25064 Hovorcovice (CZ)
(74) Vertreter: advotec.
(86) Internationale Anmeldenummer: PCT/EP2020/062460
(87) Internationale Veröffentlichungsnummer: WO 2020/229233

(56) Entgegenhaltungen:
- CN-A- 104 934 356
- DE-A1- 102011 075 001
- US-A1- 2008 146 124
- US-A1- 2012 216 396

## Beschreibung

Die vorliegende Erfindung betrifft eine Vakuumspannvorrichtung zum Aufspannen von Werkstücken, insbesondere zum Aufspannen von flachen Substraten, wie z.B. Wafern, mit einer, eine Ansaugoberfläche aufweisenden Grundplatte sowie einer Mehrzahl in der Ansaugoberfläche der Grundplatte ausgebildeten Ansaugöffnungen, wobei die Grundplatte über mindestens eine Saugleitung mit mindestens einer Unterdruckvorrichtung verbunden ist.

Derartige Vakuumspannvorrichtungen sind im Stand der Technik grundsätzlich bereits bekannt. Generell verfügen solche Vakuumspannvorrichtungen über eine Vakuumspannplatte (Grundplatte), die über ihre Fläche verteilt eine Mehrzahl von Ansaugöffnungen aufweist. Vakuumspannvorrichtungen der genannten Art werden in den unterschiedlichsten technischen Gebieten eingesetzt.

Ein solches technisches Gebiet stellt z.B. die Bearbeitung und Untersuchung von Substraten in Form von Wafern dar. Ein Wafer ist grundsätzlich größtenteils eine kreisrunde oder viereckige Scheibe, auf der sich elektronische Bauelemente befinden. Während der Bearbeitung solcher Wafer befinden sich diese in der Regel auf bzw. in einer Bearbeitungsvorrichtung, die beispielsweise einen Bearbeitungstisch aufweisen kann. Der Bearbeitungstisch verfügt über eine Halteeinrichtung, auf der ein zu bearbeitender Wafer während der Bearbeitung angeordnet ist, und auf der der Wafer, beispielsweise mittels Vakuum, angesaugt wird oder ist.

Aus der DE 20 2013 100 632 U1 ist beispielsweise eine Vakuumspannvorrichtung bekannt, welche eine Vakuumspannplatte mit einer Mehrzahl von gleichmäßig in der Ansaugoberfläche ausgebildeten Ansaugöffnungen aufweist. Bei dieser bekannten Vorrichtung wird auf der Vakuumspannplatte eine weitere Vakuumplatte aufgelegt. Diese Vakuumplatte, die bei der bekannten Lösung als eine Art Matte ausgebildet ist, kann sich an das aufzuspannende Werkstück beim Anlegen eines Vakuums anschmiegen. Hierzu besitzt die Vakuumplatte eine Anzahl von Vakuumkanälen. Die Vakuumkanäle sind mit den Ansaugöffnungen in der unter der Vakuumplatte liegenden Vakuumspannplatte verbunden, sodass das Vakuum an der Oberfläche des aufzuspannenden Werkstücks erzeugt werden kann.

US 2008/146124 A1 offenbart eine Vakuumspannvorrichtung zum Aufspannen von Werkstücken, insbesondere zum Aufspannen von flachen Substraten mit einer eine Ansaugoberfläche aufweisenden Grundplatte, wobei in der Ansaugoberfläche der Grundplatte eine Mehrzahl von Ansaugöffnungen ausgebildet ist. Die Grundplatte ist über eine Saugleitung mit einer Unterdruckvorrichtung verbindbar.

Auch die CN 104934356 A beschreibt eine ähnliche Vakuumspannvorrichtung zum Aufspannen von Werkstücken.

US 2012/0216396 beschreibt ebenfalls eine Vakuumspannvorrichtung zum Aufspannen von Waferr

DE 10 2011 075001 A1 offenbart eine Durch Licht-Vakuumspannvorrichtung mit einer lichtdurchlässigen Platte, die zwischen dem Körper der Spannvorrichtung und einem zu tragenden Wafer angeordnet ist und aus porösem Material mit mehreren miteinander verbundenen Poren besteht, die Gasdurchlass Kanäle bilden.

Neben der Bearbeitung stellt auch die Untersuchung von Wafern ein wichtiges Arbeitsfeld dar. So muss nach der Herstellung von Wafern häufig eine optische Inspektion durchgeführt werden, um Fehler in der Produktion zu finden und auszumerzen. Dabei muss die Oberfläche des zu untersuchenden Wafers mittels Licht untersucht werden. Insbesondere ist es wünschenswert, wenn bei dieser optischen Inspektion die Wafer sowohl mit Auflicht als auch mit Durchlicht untersucht werden können. Vor dieser Untersuchung ist es wichtig, dass ein zu untersuchender Wafer glatt "gezogen" wird. Dies erfolgt in der Regel mit Hilfe einer oben genannten Vakuumspannvorrichtung.

Dabei geht das Vakuumspannen insbesondere von dem Grundsatz aus, dass außerhalb und innerhalb einer Vakuumspannvorrichtung, die als Vakuumtisch ausgebildet sein kann, zunächst der normale atmosphärische Luftdruck anliegt, der in der Regel etwa 1 bar beträgt. Nun wird der aufzuspannende Wafer auf die Vakuumspannvorrichtung aufgebracht. Mit einer Vakuumeinrichtung, beispielsweise einer Vakuumpumpe wird die Luft im Inneren der Vakuumspannvorrichtung abgesaugt. Dadurch entsteht eine Druckdifferenz zwischen innen und außen, deren Grenzschicht das aufzuspannende Werkstück darstellt. Zwischen dem Werkstück, insbesondere Wafer, und der Vakuumspannvorrichtung wird somit ein Vakuum erzeugt. Hierbei handelt es sich insbesondere um einen Unterdruck, der wesentlich, d.h. der um ein Vielfaches geringer ist als der Umgebungsdruck, etwa der atmosphärische Luftdruck. Der atmosphärische Luftdruck drückt nun das Werkstück an die Vakuumspannvorrichtung an. Nun kann die Oberseite des nun eben vorliegenden Werkstücks untersucht werden, ohne dass das Werkstück dabei wegrutschen kann.

Der Nachteil der aus dem Stand der Technik bekannten Vakuumspannvorrichtungen besteht darin, dass eine optische Inspektion des aufgespannten Werkstücks, insbesondere Wafers nur unzureichend möglich ist, da die in der Ansaugoberfläche der Grundplatte ausgebildeten Ansaugöffnungen, welche gleichmäßig über die Ansaugoberfläche verteilt sind, eine optische Inspektion stören oder sogar unmöglich machen. Diese Ansaugöffnungen erzeugen beispielsweise Schatten, welche einer optischen Inspektion durch Auflicht bzw. Durchlicht äußerst störend entgegenstehen. Des Weiteren ist es mit den bekannten Vorrichtungen kaum oder nicht möglich, stark gewölbte Werkstücke glatt zu "ziehen".

Der vorliegenden Erfindung liegt die Aufgabe zugrunde, die Nachteile der Vakuumspannvorrichtungen aus dem Stand der Technik zu überwinden. Der Erfindung liegt insbesondere die Aufgabe zugrunde, eine Vakuumspannvorrichtung zur Verfügung zu stellen, mit welcher ein Werkstück, insbesondere ein Wafer zum einen flach auf die Grundplatte aufgespannt und gleichzeitig einer optimalen optischen Inspektion unterzogen werden kann.

Diese Aufgabe wird erfindungsgemäß durch eine Vakuumspannvorrichtung mit den Merkmalen des Anspruchs 1 gelöst. Hierbei ist es besonders erstrebenswert, dass die Ansaugöffnungen ausschließlich in einem peripheren der Ansaugoberfläche der Grundplatte angeordnet sind. Es hat sich überraschenderweise herausgestellt, dass mit der erfindungsgemäßen Vakuumspannvorrichtung ein optimales Aufspannen und "Glattziehen" von Wafern möglich ist, obwohl die Ansaugöffnungen nicht gleichmäßig über die Ansaugoberfläche der Grundplatte verteilt, sondern in einem peripheren Bereich der Ansaugoberfläche der Grundplatte angeordnet sind. Durch die Tatsache, dass sich die Ansaugöffnungen in einem peripheren Bereich der Ansaugoberfläche der Grundplatte befinden, kann der Wafer quasi vollständig mit Durchlicht inspiziert werden, da keine störenden Öffnungen in Form von Ansaugöffnungen in der zu inspizierenden Fläche vorhanden sind. Dadurch können Strukturen mit maximalem Kontrast inspiziert werden. Durch die zwischen der Grundplatte und dem aufzuspannenden Werkstück angeordnete, transparent und flexibel ausgebildete Folie, welche im Bereich der Peripherie des Werkstücks Ansaugaussparungen aufweist, können auch stark gewölbte Werkstücke mittels eines zwischen der Folie und dem Werkstück angelegten Vakuums flach auf die Grundplatte gezogen werden. Die Folie schmiegt sich beim Anlegen eines Vakuums an das Werkstück an und zieht dieses quasi mit auf die Grundplatte der erfindungsgemäßen Vorrichtung. Auf diese Art und Weise kann auch ein stärker gewölbtes Werkstück flach auf die eben ausgebildete Grundplatte aufgelegt werden. Wafer sind häufig gewölbt (im Maximum bis zu 500 µm). Da die genannte Folie transparent ausgebildet ist und ebenfalls nur an ihrer Peripherie über Ansaugaussparungen verfügt, ist auch bei Verwendung einer solchen Folie eine ungestörte optische Inspektion mittels Durchlicht möglich. Beim Ansaugen des Werkstücks auf der Grundplatte nimmt die Folie zunächst die Form des Werkstücks an. Ist dies erfolgt, wird ein noch stärkeres Vakuum zwischen der Folie und der Grundplatte aufgebaut, sodass die Folie gänzlich auf die Grundplatte gezogen wird und die Form des Tisches annimmt.

Vorzugsweise ist die oben genannte flexible Folie aus Glas gefertigt. Eine derartige Folie hat sich als besonders vorteilhaft erwiesen, da diese kaum anfällig für Kratzer ist. Im Gegensatz zu Glasfolien sind beispielsweise Folien aus Plexiglas anfällig für Kratzer, was bei einer optischen Inspektion mit einer Auflösung von 1 µm nicht vorteilhaft ist.

Mit Vorteil ragt die oben genannte Folie über den Rand des Werkstückes und/oder der Grundplatte hinaus. Hierdurch ist ein besonders stabiles Vakuum zwischen der Folie und der Grundplatte und damit auch zwischen der Folie und dem zu untersuchenden Werkstück erzeugbar.

Um eine optimale optische Inspektion zu ermöglichen, ist die Grundplatte in aller Regel transparent, insbesondere im Wesentlichen aus Glas oder transparentem Kunststoff, wie beispielsweise Plexiglas gefertigt.

Mit Vorteil besteht zwischen den Ansaugöffnungen und dem Rand der Grundplatte ein Abstand, insbesondere ein Abstand von ca. 1 bis ca. 30 mm. Durch die Tatsache, dass die Ansaugöffnungen etwas vom Rand der Grundplatte beabstandet angeordnet sind, entsteht zwischen den Ansaugöffnungen und dem äußersten Rand der Grundplatte ein Randabschnitt, welcher beim Auflegen einer unten näher dargestellten Folie nach außen hin abdichtend wirkt. Dadurch kann ein besonders starkes Vakuum zwischen der Grundplatte und dem zu untersuchenden Werkstück angelegt werden.

Mit Vorteil sind die Ansaugöffnungen rund ausgebildet. Diese Ausführungsform ist einfacher in der Herstellung und weist gleichzeitig optimale Ansaugeigenschaften auf.

Bei einer bevorzugten Ausführungsform der erfindungsgemäßen Vakuumspannvorrichtung schließt sich an mindestens zwei Ansaugöffnungen jeweils ein sich durch die Grundplatte erstreckender Ansaugkanal an, welcher sich vorzugsweise zur Ansaugoberfläche hin erweitert. Mit dieser Ausführungsform kann schnell ein besonders starkes Vakuum zwischen der Grundplatte und dem Werkstück erzeugt werden.

In der Regel weisen mindestens zwei Ansaugöffnungen einen Anschluss für eine Ansaugleitung auf und/oder sind mit einer Ansaugleitung verbunden.

Vorzugsweise sind die Ansaugöffnungen auf einer Umrisslinie angeordnet sind, welche im Wesentlichen der Kontur des aufzuspannenden Objekts entspricht. Ist also das Objekt z.B. quadratisch ausgebildet, so sind die Ansaugöffnungen ebenfalls in Form eines Quadrats angeordnet.

Ist das aufzuspannende Objekt ein Wafer, sind die Ansaugöffnungen vorzugsweise auf einem imaginären, insbesondere an einer Stelle abgeflacht ausgebildeten Ring in der Ansaugoberfläche der Grundplatte angeordnet, wobei die Größe des Ringes etwas geringer ist als die Größe des Wafers, sodass die Ansaugöffnungen vom Wafer gerade noch bedeckt werden können. Durch diese ringförmige Anordnung lässt sich ein besonders hohes und gleichmäßiges Vakuum zwischen der Grundplatte der Vakuumspannvorrichtung und dem zu untersuchenden Wafer herstellen.

Weitere Merkmale der Erfindung ergeben sich aus der nachfolgenden Beschreibung von bevorzugten Ausführungsbeispielen der Erfindung in Verbindung mit den Zeichnungen und den Unteransprüchen.

In den Zeichnungen zeigen:
- Fig. 1:: eine perspektivische Darstellung einer erfindungsgemäßen Vakuumspannvorrichtung;
- Fig. 2:: eine Draufsicht auf die Vakuumspannvorrichtung von Fig. 1;
- Fig. 3a:: eine Seitenansicht der Vakuumspannvorrichtung von Fig. 1 in einem offenen Zustand;
- Fig. 3b:: eine Seitenansicht der Vakuumspannvorrichtung von Fig. 1 in einem geschlossenen Zustand;
- Fig. 4a:: einen Schnitt entlang der Linie B-B der Vakuumspannvorrichtung von Fig. 3a;
- Fig. 4b:: einen Schnitt entlang der Linie G-G der Vakuumspannvorrichtung von Fig. 3b;
- Fig. 5:: einen vergrößerten Ausschnitt (Ausschnitt K) aus Fig. 4b;
- Fig. 6:: einen vergrößerten Ausschnitt (Ausschnitt C) aus Fig. 4a;
- Fig. 7:: eine Seitenansicht der Vakuumspannvorrichtung gemäß Fig. 1 im Bereich von Vakuumanschlüssen;
- Fig. 8:: einen vergrößerten Ausschnitt (Ausschnitt A) aus Fig. 2 im Bereich der Ansaugöffnungen;
- Fig. 9:: einen vergrößert dargestellten Vakuumanschluss;
- Fig. 10:: einen vergrößerten Ausschnitt aus Fig. 6.

Nachfolgend werden gleiche oder funktionsgleiche Merkmale mit gleichen Bezugszeichen gekennzeichnet.

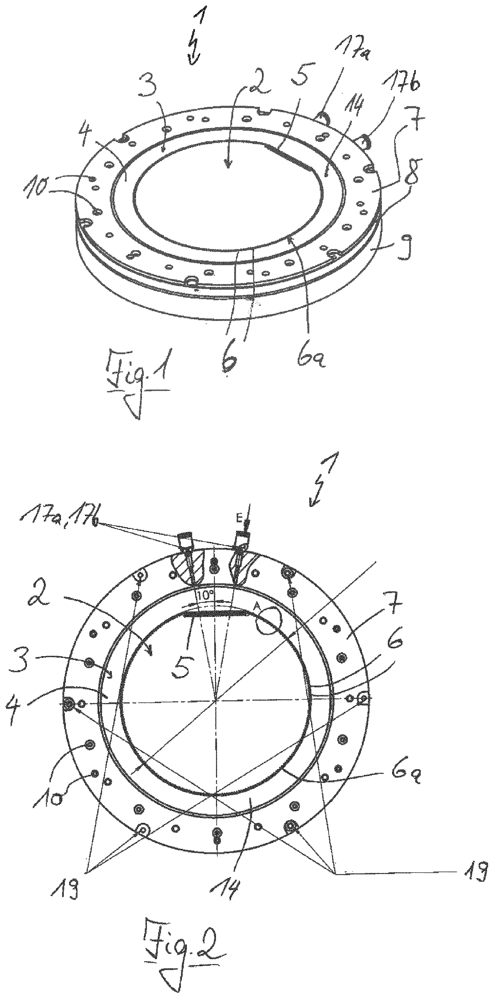

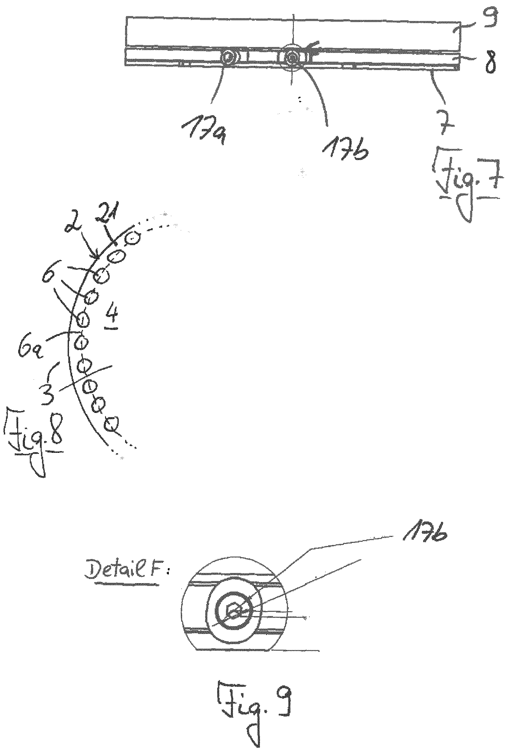

In den Figuren 1 und 2 ist eine erfindungsgemäße Vakuumspannvorrichtung in Form eines Vakuumtisches 1 dargestellt. Auf dem Vakuumtisch 1 ist ein Wafer 2 aufgespannt, welcher einer optischen Inspektion unterzogen werden soll. Der Vakuumtisch 1 umfasst eine Grundplatte 3, welche eine Ansaugoberfläche 4 aufweist. Die Grundplatte 3 ist aus Glas gefertigt. Der auf der Grundplatte 3 aufliegende Wafer 2 ist im Wesentlichen kreisrund ausgebildet, wobei der Wafer 2 an einer Stelle 5 abgeflacht ausgebildet ist, um diesen besser greifen zu können. In der Ansaugoberfläche 4 der Grundplatte 3 ist eine Vielzahl von Ansaugöffnungen 6 ausgebildet. Die Ansaugöffnungen 6 sind auf einem imaginären Ring 6a, welcher an einer Stelle abgeflacht ausgebildet ist, in der Ansaugoberfläche 4 der Grundplatte 3 angeordnet. Die Form dieses imaginären Ringes 6a entspricht der Form des Wafers 2, wobei dieser Ring 6a geringfügig kleiner ausgebildet ist als der Wafer 2, sodass der Wafer 2 den imaginären Ring 6a mit den Ansaugöffnungen 6 gerade noch überdeckt. Diese Anordnung der Ansaugöffnungen 6 und des Wafers 2 ist in Fig. 8 gut zu erkennen. Hier ist der Wafer zur besseren Illustrierbarkeit transparent dargestellt, sodass die Ansaugöffnungen zu sehen sind.

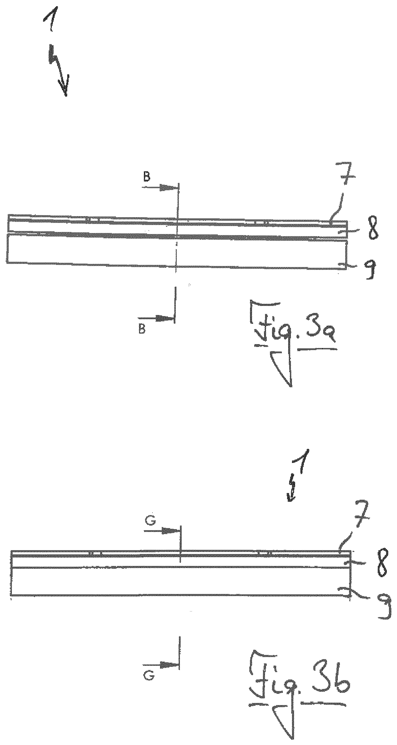

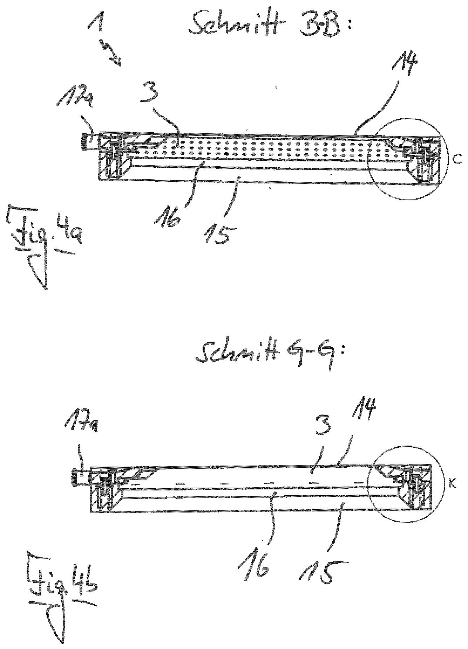

Der Vakuumtisch 1 umfasst ferner einen oberen Ring 7, einen mit dem oberen Ring 7 verbundenen Haltering 8 zum Fixieren der Grundplatte 3 sowie einen unteren Ring 9. Die Ringe 7, 8 und 9 sind aus Aluminium gefertigt und über Schraubverbindungen miteinander verbunden. In den Figuren 1 und 2 sind Aussparungen 10 im oberen Ring 7 zum Einführen von Befestigungsschrauben zu erkennen. Des Weiteren weist der obere Ring 7 eine Mehrzahl von Einbuchtungen 19 auf. Diese Einbuchtungen 19 dienen zum Einfügen von Justiervorrichtungen, die ein bestimmtes Maß an vertikaler Beweglichkeit der Ringe 7, 8 und 9 vorgeben. Zum Aufheben eines Vakuums wird der Haltering 8 etwas angehoben. Diese "Offenstellung" ist in den Figuren 3a, 4a sowie 6 dargestellt. In den Figuren 3b, 4b sowie 5 ist die "Schließstellung" dargestellt, bei welcher die Ringe 8 und 9 aufeinander liegen.

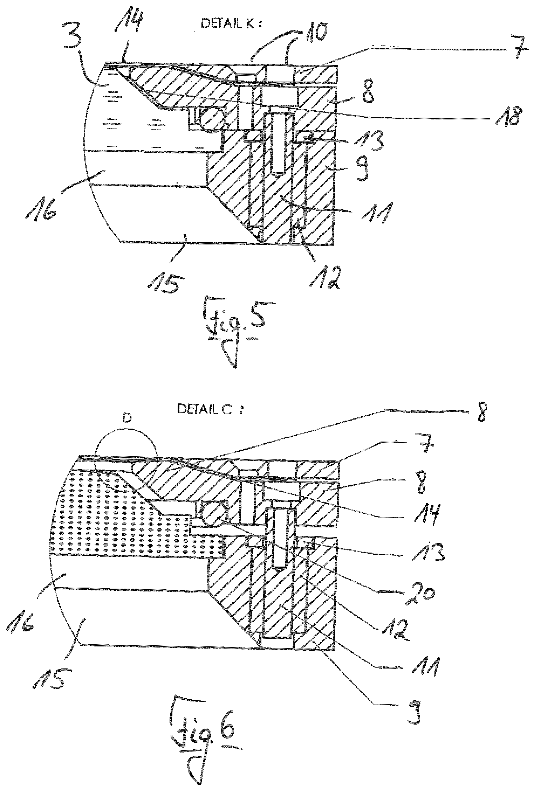

Der Haltering 8 weist ferner einen O-Ring 20 auf, welcher im Schließzustand des Vakuumtisches 1 für eine optimale Abdichtung nach außen sorgt. Der Hubmechanismus des Vakuumtisches 1 umfasst ferner eine Führungsstange 11 sowie eine mit der Führungsstange 11 verbundene Kugelbuchse 12. Am oberen Ende der Kugelbuchse ist eine Abdeckung 13 vorgesehen. Diese Elemente sind in den Figuren 5 und 6 gut zu erkennen.

Zwischen der Grundplatte 3 und dem Wafer 2 ist eine flexibel ausgebildete Glasfolie 14 angeordnet, welche Ansaugaussparungen aufweist. Die Ansaugaussparungen der Glasfolie 14 sind so angeordnet, dass sie über den Ansaugöffnungen 6 in der Ansaugoberfläche 4 der Grundplatte 3 angeordnet sind. Die Ansaugaussparungen in der Glasfolie 14 sind also ebenfalls auf einem, an einer Stelle abgeflacht ausgebildeten imaginären Ring angeordnet. Zur Fixierung der Glasfolie 14 ist diese zwischen dem oberen Ring 7 und dem Haltering 8 eingespannt.

Auf der der Grundplatte 3 entgegengesetzten unteren Seite des Vakuumtisches 1 ist dieser durch eine Abschlussplatte 15 nach außen hin abgeschlossen. Im Schließzustand sorgt die Abschlussplatte 15 für eine hermetische Abdichtung des Innenraumes 16 zwischen der Grundplatte 3 und der Abschlussplatte 15.

Zum Aufspannen eines Wafers wird wie folgt vorgegangen.

Zunächst wird der Wafer 2 mit Hilfe eines Transportführlöffels (hier nicht dargestellt) so auf die Grundplatte 3 aufgelegt, dass der Wafer 2 sämtliche Ansaugöffnungen 6 in der Ansaugoberfläche 4 der Grundplatte 3 bedeckt. Wie bereits oben erwähnt, entspricht die Anordnung der Ansaugöffnungen 6 in der Grundplatte 3 der Form des Wafers 2, wobei der Wafer 2 geringfügig größer ausgebildet ist als der imaginäre, abgeflachte Ring 6a, auf dem die Ansaugöffnungen 6 angeordnet sind. Durch die Tatsache, dass der Wafer 2 nur geringfügig größer ausgebildet ist als der imaginäre Ring 6a, wird erreicht, dass der Wafer 2 nur minimal über dem imaginären Ring mit den Ansaugöffnungen 6 hinausragt und so nur ein äußerst kleiner Abschnitt 21 des Wafers 2 über den Ring 6a übersteht. Auf diese Art und Weise kann Wafermaterial eingespart werden. Zwischen dem Wafer 2 und der Grundplatte 3 befindet sich die Glasfolie 14, deren Ansaugaussparungen direkt über den Ansaugöffnungen 6 in der Grundplatte 3 positioniert sind.

Spätestens jetzt wird der Vakuumtisch 1 von der geöffneten Position in die Schließstellung verbracht. Dies erfolgt durch Absenken des Halteringes 8 auf den unteren Ring 9.

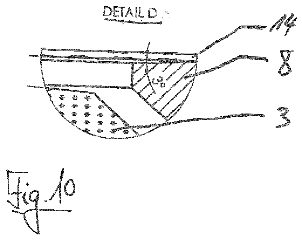

Da der Wafer 2 nicht gerade, sondern etwas gebogen ausgebildet ist und mit Hilfe des Vakuumtisches 1 flach gezogen werden muss, schließt die Glasfolie 14 mit dem Haltering 8 einen Winkel von ca. 3° ein. Hierdurch wird eine Anpassung an den uneben ausgebildeten Wafer 2 erreicht, Auf diese Art und Weise kann schneller ein ausreichend starkes Vakuum zwischen dem Wafer 2 und der Glasfolie 14 aufgebaut werden. Die Anordnung der Glasfolie 14 ist in Fig. 10 gut zu erkennen.

Zur Erzeugung eines Vakuums wird nun über die Vakuumanschlüsse 17a und 17b die Luft aus dem Innenraum 16 gepumpt. Mindestens eine der Ansaugöffnungen 6 ist mit einem Vakuumkanal 18 verbunden, welcher wiederum in offener Verbindung mit einem der Vakuumanschlüsse 17a oder 17b steht. Durch das entstehende Vakuum wird der Wafer 2 zunächst im Bereich der mit dem Vakuumkanal 18 in Verbindung stehenden Ansaugöffnung auf die Glasfolie 14 gezogen. Dies ist deshalb besonders gut möglich, da die Ansaugaussparungen in der Glasfolie 14 direkt über den Ansaugöffnungen 6 positioniert sind und auf diese Weise das Vakuum direkt auf den Wafer 2 wirken kann. Sämtliche Ansaugöffnungen 6 stehen miteinander in offener Verbindung. Dies kann beispielsweise dadurch erfolgen, dass die Ansaugöffnungen 6 die Grundplatte 3 komplett von ihrer Oberseite bis zu ihrer Unterseite durchziehen und dadurch über den Innenraum 16 in offener Verbindung miteinander stehen. Durch die Tatsache, dass die Ansaugöffnungen 6 miteinander in offener Verbindung stehen, breitet sich das Vakuum schnell über sämtliche Ansaugöffnungen 6 aus, sodass der Wafer schließlich über sämtliche Ansaugöffnungen 6 auf die Glasfolie 14 bzw. die Grundplatte 3 gezogen wird. Der Wafer 2 wirkt als eine Art "Deckel", mit dem es erst möglich ist, ein Vakuum zwischen dem Wafer und der Grundplatte 3 bzw. der Glasfolie 14 zu erzeugen und damit den Wafer 2 eben auf die Grundplatte 3 zu ziehen. In dieser ebenen Form kann der Wafer 2 nun optimal optisch inspiziert werden. Durch die Tatsache, dass die Ansaugöffnungen 6 allesamt in einem peripheren Bereich der Grundplatte 3 und im äußersten Randbereich des zu inspizierenden Wafers 2 angeordnet sind, wirken diese Ansaugöffnungen 6 nicht störend auf eine optische Inspektion des Wafers 2. So kann bis auf den äußersten Randbereich eine optische Inspektion des Wafers 2 ohne störende Verschattungen durch Ansaugöffnungen erfolgen, da innerhalb des Ringes 6a keine Ansaugöffnungen vorgesehen sind. Gleichzeitig hat sich herausgestellt, dass durch die Anordnung der Ansaugöffnungen 6 im äußersten Randbereich des zu inspizierenden Wafers 2 ein äußerst starkes Vakuum erzeugbar ist, durch welches ein unebener Wafer fest und sicher glattgezogen werden kann.

Im vorliegenden Ausführungsbeispiel weist der Wafer 2 einen Durchmesser von 15 cm auf. Die Ansaugöffnungen weisen einen Durchmesser von 0,5 mm auf.

## Patentansprüche

1. Vakuumspannvorrichtung (1) zum Aufspannen von Werkstücken, insbesondere zum Aufspannen von flachen Substraten, wie z.B. von Wafern (2), mit einer eine Ansaugoberfläche (4) aufweisenden Grundplatte (3), wobei in der Ansaugoberfläche (4) der Grundplatte (3) eine Mehrzahl von Ansaugöffnungen (6) ausgebildet ist, wobei die Grundplatte (3) über mindestens eine Saugleitung mit mindestens einer Unterdruckvorrichtung verbindbar ist, wobei die Ansaugöffnungen (6) in einem peripheren Bereich der Ansaugoberfläche (4) der Grundplatte (3) angeordnet sind, **gekennzeichnet durch** eine, zwischen der Grundplatte (3) und dem aufzuspannenden Werkstück (2) angeordnete, transparente und flexibel ausgebildete Folie (14), welche im Bereich der Peripherie des Werkstückes Ansaugaussparungen aufweist.

2. Vakuumspannvorrichtung nach Anspruch 1, **dadurch gekennzeichnet, dass** zwischen den Ansaugöffnungen (6) und dem äußeren Rand der Grundplatte (3) ein Abstand, insbesondere ein Abstand von ca. 1 bis ca. 30 mm besteht.

3. Vakuumspannvorrichtung nach einem der Ansprüche 1 oder 2, **dadurch gekennzeichnet, dass** die Ansaugöffnungen (6) rund ausgebildet sind und vorzugsweise einen Durchmesser von ca. 0,3 bis 1,5 mm, insbesondere von ca. 0,8 bis 1,3 mm aufweisen.

4. Vakuumspannvorrichtung nach einem der vorhergehenden Ansprüche, **dadurch gekennzeichnet, dass** sich an mindestens eine Ansaugöffnung (6) ein sich in die Grundplatte (3) erstreckender Ansaugkanal (18) anschließt, welcher sich vorzugsweise zur Ansaugoberfläche (4) hin erweitert.

5. Vakuumspannvorrichtung nach einem der vorhergehenden Ansprüche, **dadurch gekennzeichnet, dass** mindestens zwei Ansaugöffnungen (6) einen Anschluss für eine Ansaugleitung aufweisen und/oder mit einer Ansaugleitung verbunden sind.

6. Vakuumspannvorrichtung nach einem der vorhergehenden Ansprüche, **dadurch gekennzeichnet, dass** die Ansaugöffnungen (6) auf einer Umrisslinie, welche im Wesentlichen der Kontur des aufzuspannenden Werkstücks (2) entspricht, vorzugsweise auf einem, vorzugsweise an einer Stelle (5) abgeflacht ausgebildeten Ring (6a) in der Ansaugoberfläche (4) der Grundplatte (3) angeordnet sind, wobei die AnsaugÖffnungen (6) vorzugsweise derart angeordnet sind, dass sie vom aufzuspannenden Werkstück (2) bedeckt werden können.

7. Vakuumspannvorrichtung nach einem der vorhergehenden Ansprüche, **dadurch gekennzeichnet, dass** die Grundplatte transparent, insbesondere in Wesentlichen aus Glas oder transparentem Kunststoff gefertigt ist.

8. Vakuumspannvorrichtung nach einem der vorhergehenden Ansprüche, **dadurch gekennzeichnet, dass** die Aussparungen direkt über den Ansaugöffnungen (6) angeordnet sind.

9. Vakuumspannvorrichtung nach Anspruch 8, **dadurch gekennzeichnet, dass** die Folie (14) aus Glas gefertigt ist.

10. Vakuumspannvorrichtung nach einem der Ansprüche 8 oder 9, **dadurch gekennzeichnet, dass** die Folie (14) über den Rand des Werkstückes (2) und/oder der Grundplatte (3) hinausragt.

## Claims

1. A vacuum clamping device (1) for clamping workpieces, in particular for clamping flat substrates such as wafers (2), the vacuum clamping device having a base plate (3) which comprises a suction surface (4), a plurality of suction openings (6) being realized in the suction surface (4) of the base plate (3), the base plate (3) being configured to be connected to at least one vacuum device via at least one suction pipe, the suction openings (6) being disposed in a periphery region of the suction surface (4) of the base plate (3), **characterized by** a transparent and flexible film (14) which is disposed between the base plate (3) and the workpiece (2) to be clamped and which has suction clearances in the region of the periphery of the workpiece.

2. The vacuum clamping device according to claim 1, **characterized in that** there is a gap, in particular of approximately 1 to approximately 30 mm, between the suction openings (6) and the outer edge of the base plate (3).

3. The vacuum clamping device according to any one of claims 1 or 2, **characterized in that** the suction openings (6) are round and preferably have a diameter of approximately 0.3 to 1.5 mm, in particular approximately 0.8 to 1.3 mm.

4. The vacuum clamping device according to any one of the preceding claims, **characterized in that** a suction channel (18) adjoins at least one suction opening (6), said suction channel extending into the base plate (3) and preferably widening towards the suction surface (4).

5. The vacuum clamping device according to any one of the preceding claims,
**characterized in that** at least two suction openings (6) comprise a connection for a suction pipe and/or are connected to a suction pipe.

6. The vacuum clamping device according to any one of the preceding claims, **characterized in that** the suction openings (6) are disposed on an outline, which essentially corresponds to the contour of the workpiece (2) to be clamped, preferably on a ring (6a), which is preferably flat in one point (5), in the suction surface (4) of the base plate (3), the suction openings (6) preferably being disposed in such a manner that they are configured to be covered with the workpiece (2) to be clamped.

7. The vacuum clamping device according to any one of the preceding claims,
**characterized in that** the base plate is transparent and is in particular essentially made of glass or a transparent plastic material.

8. The vacuum clamping device according to any one of the preceding claims, **characterized in that** the clearances are disposed directly above the suction openings (6).

9. The vacuum clamping device according to claim 8, **characterized in that** the film (14) is made of glass.

10. The vacuum clamping device according to any one of claims 8 or 9, **characterized in that** the film (14) protrudes beyond the edge of the workpiece (2) and/or of the base plate (3).

## Revendications

1. Dispositif (1) de serrage à vide pour serrer des pièces de fabrication, notamment pour serrer des substrats plats, comme par exemple des tranches (2), ledit dispositif de serrage à vide ayant une plaque de base (3) ayant une surface d'aspiration (4), une pluralité d'ouvertures d'aspiration (6) étant réalisée dans la surface d'aspiration (4) de la plaque de base (3), la plaque de base (3) étant capable d'être reliée à au moins un dispositif à vide via au moins une conduite d'aspiration, les ouvertures d'aspiration (6) étant disposées dans une zone périphérique de la surface d'aspiration (4) de la plaque de base (3), **caractérisé par** un film (14) transparent et flexible qui est disposé entre la plaque de base (3) et la pièce de fabrication (2) à serrer et qui a des évidements d'aspiration dans la zone de la périphérie de la pièce de fabrication.

2. Dispositif de serrage à vide selon la revendication 1, **caractérisé en ce qu'**il existe un espacement, notamment un espacement d'environ 1 à environ 30 mm, entre les ouvertures d'aspiration (6) et le bord extérieur de la plaque de base (3).

3. Dispositif de serrage à vide selon la revendication 1 ou 2, **caractérisé en ce que** les ouvertures d'aspiration (6) sont rondes et ont, de préférence, un diamètre d'environ 0,3 à 1,5 mm, notamment d'environ 0,8 à 1,3 mm.

4. Dispositif de serrage à vide selon l'une quelconque des revendications précédentes, **caractérisé en ce qu'**un canal d'aspiration (18) est raccordé à au moins une ouverture d'aspiration (6), ledit canal d'aspiration s'étendant dans la plaque de base (3) et, de préférence, s'élargissant vers la surface d'aspiration (4).

5. Dispositif de serrage à vide selon l'une quelconque des revendications précédentes, **caractérisé en ce qu'**au moins deux ouvertures d'aspiration (6) ont un raccordement pour une conduite d'aspiration et/ou sont reliées à une conduite d'aspiration.

6. Dispositif de serrage à vide selon l'une quelconque des revendications précédentes, **caractérisé en ce que** les ouvertures d'aspiration (6) sont disposées sur une ligne de contour, qui correspond essentiellement au contour de la pièce de fabrication (2) à serrer, de préférence sur une bague (6a), qui est de préférence aplatie à un endroit (5), dans la surface d'aspiration (4) de la plaque de base (3), les ouvertures d'aspiration (6) de préférence étant disposées de manière qu'ils sont capables d'être couvertes par la pièce de fabrication (2) à serrer.

7. Dispositif de serrage à vide selon l'une quelconque des revendications précédentes, **caractérisé en ce que** la plaque de base est transparente, notamment faite essentiellement de verre ou de plastique transparent.

8. Dispositif de serrage à vide selon l'une quelconque des revendications précédentes, **caractérisé en ce que** les évidements sont disposés directement au-dessus des ouvertures d'aspiration (6).

9. Dispositif de serrage à vide selon la revendication 8, **caractérisé en ce que** le film (14) est fait de verre.

10. Dispositif de serrage à vide selon la revendication 8 ou 9, **caractérisé en ce que** le film (14) fait saillie au-delà du bord de la pièce de fabrication (2) et/ou de la plaque de base (3).
